# EUROPEAN PATENT SPECIFICATION

(11) **EP 0 312 924 B1**
(45) Date of publication and mention of the grant of the patent: **21.04.1993**
(21) Application number: 88117091.4
(22) Date of filing: 14.10.1988
(51) Int. Cl.: B65G 47/91, H01L 21/00

(54) **Vacuum chucking tool and system**
Werkzeug und System zum Spannen mittels Vakuum
Instrument et système de serrage à l'aide de vacuum

(30) Priority: 22.10.1987 JP 267119/87
(43) Date of publication of application: 26.04.1989
(73) Proprietor: FUJITSU LIMITED, Kawasaki-shi, Kanagawa 211 (JP)
(72) Inventor: Ogawa, Tsutomu c/o Fujitsu Limited, Kawasaki-shi Kanagawa 211 (JP)
(74) Representative: Sunderland, James Harry

(56) References cited:
- EP-A- 0 134 621
- GB-A- 1 054 966
- US-A- 2 812 061
- US-A- 3 999 795

## Description

The present invention relates to a vacuum chucking tool and to a vacuum chucking system applicable, for instance, for wet processing in semiconductor manufacturing.

In semiconductor manufacturing processes, there are many occasions upon which the handling of semiconductor substrates or wafers is needed, to load, reload or unload the substrates or wafers to/from a carrier or holder. For such handling, tweezers or forceps are widely used. However, with a view to avoiding flaws or damage caused by tweezers, vacuum chucks or Bernoulli flow chucks are increasingly being used.

Semiconductor processing includes many treatments which use water or chemicals. Such processing is called wet processing, as against dry processing in which a wafer is treated in air or in a gassy ambient. Many processes are carried out as batch processes, in order to increase throughput. Several wafers are loaded into a holder, and together immersed into chemicals to process the wafers. In such batch processing systems, especially in wet processing, stains are sometimes left at portions of the wafers which contact the holder, and this spoils the uniformity of the processing. The prevention of such stains is a problem in wet processing.

From the viewpoint of the uniformity of the products, however, a one-by-one processing system is better than a batch system. This is because each wafer can be checked, and the holding point of the wafer can be shifted to prevent staining. Sometimes the wafer is held by its back surface, to protect the front surface from effects caused by contact with a tool. In such a case, the wafer chuck is very important. For dry processes, vacuum chucks or Bernoulli flow chucks can be used, but there is no vacuum chuck which can be used in wet processes.

US-A-2 812 061 discloses an automatic, pneumatic object sorting machine intended for sorting potatoes from the soil aggregate dug up by a travelling potato digger, or other objects. Th machine has a vacuum chuck capable of being evacuated or pressurized when connected to a pneumatic system, for clamping or releasing an object (a potato) to or from the vacuum chuck, the vacuum chuck having:-
a cup (2) for holding the object;
an inlet formed in the cup for sucking the object towards the cup, the inlet being connected to the cup cavity;
a fitting (5) for supporting the cup;
a connection means provided on the fitting (5) for connecting the chuck to the pneumatic system;
a manifold (5b) formed in the fitting (5), for connecting the cup cavity to the connection means; and
a dust screen (7) at the bottom of the fitting (5), near the cup (2).

According to the present invention there is provided a vacuum chucking tool operable in a liquid and comprising a vacuum chuck capable of being evacuated or pressurized when connected to a pneumatic system, for clamping or releasing an object to or from the vacuum chuck, the vacuum chuck having:-
a head for holding the object;
a cavity formed in the head;
an inlet formed in the head for sucking the object towards the head, the inlet being connected to the cavity;
a holder for supporting the head;
a connection means provided on the holder for connecting the chuck to the pneumatic system;
a manifold formed in the holder, for connecting the cavity to the connection means;
and
a liquid-gas separating membrane for separating gas from liquid in a mixture of liquid and gas, the liquid-gas separating membrane being spanned between the cavity and the manifold, or between the cavity and the inlet.

An embodiment of the present invention can provide a vacuum chuck which can be used in wet processes.

An embodiment of the present invention can facilitate wafer handling in wet processes, and decrease defects arising from wafer handling.

A vacuum chuck of an embodiment of the present invention is provided with a liquid-gas separating membrane, which separates liquid from gas. The liquid-gas separating membrane is composed of material having a plurality of tiny holes which allow passage of gas but do not pass liquid. The membrane is installed between the inlet and manifold of the vacuum chuck. This makes the chuck operate in a manner similar to that of an ordinary air vacuum chuck.

A chucking system of an embodiment of the present invention comprises an aspirator for exhausting gas in the chuck, a compressor for sending compressed air or gas into the chuck, and a switching valve for switching the connection of the manifold to the compressor or to the aspirator.

When the chuck is immersed into a liquid, the liquid is stopped by the liquid-gas separating membrane and does not enter the chuck further than the membrane into the manifold. For example when used in wafer handling, the opening of the inlet of the chuck is placed to confront the wafer in the liquid. The liquid in the chuck is expelled from the chuck by compressed air or gas, and the switching valve is switched from the compressor to the aspirator, then the substrate (wafer) is sucked to the chuck and held in a manner similar to that of an ordinary air vacuum chuck. Even if a small quantity of liquid intrudes into the manifold at this instant, it is held back by the liquid-gas separating membrane, and the attracting strength of the chuck is not lost.

When a chuck or chuck tool in accordance with an embodiment of the present invention is used in air it operates similarly to an ordinary vacuum chuck. The chuck is easily and conveniently applied to various kinds of wet processing, such as washing, etching, and rinsing and so on. By holding a substrate or wafer from its back or reverse side with a vacuum chuck in accordance with an embodiment of the present invention, the front side of the substrate can be treated with various wet processes without leaving stains or damage on the front surface.

Reference is made, by way of example, to the accompanying drawings, in which:-
Figs. 1 are partial cut-away views of a vacuum chuck in accordance with an embodiment of the present invention, schematically illustrating its operation in liquid, wherein:-
Fig. 1(a) shows a state in which the chuck is immersed into liquid, with a liquid-gas separating membrane acting as a barrier to the liquid; and
Fig. 1(b) shows a state in which the chuck is evacuated and a wafer is sucked into the chuck;
Fig. 2 illustrates a basic configuration of a vacuum chucking system in accordance with an embodiment of the present invention;
Figs. 3 illustrate schematically various stages in operation of a vacuum chuck in accordance with an embodiment of the present invention, wherein:-
Fig. 3(a) shows a state in which the chuck is immersed into a liquid;
Fig. 3(b) shows a state in which liquid in the chuck is expired or expelled by compressed air or gas; and
Fig. 3(c) shows a state in which the chuck is evacuated by an aspirator, and a wafer is sucked into an opening of the chuck;
Fig. 4 gives a cross-sectional view and an end-on view of a vacuum chuck in accordance with an embodiment of the present invention, illustrating the structure of the chuck;
Figs. 5 illustrate a vacuum chuck in accordance with another embodiment of the present invention, suitable for holding a wafer vertically, wherein:-
Fig. 5(a) is a schematic front view of the chuck; and
Fig. 5(b) is a cross-sectional view of the chuck;
Fig. 6 is a schematic cross-sectional view of a further chuck in accordance with an embodiment of the present invention, which is suitable for handling a plurality of wafers at one time;
Fig. 7 illustrates an application of a vacuum chuck in accordance with an embodiment of the present invention, showing how wafers are reloaded from one wafer holder to another;
Figs. 8 show schematically one kind of typical wafer holder widely used in various semiconductor processings; wherein:-
Fig. 8(a) is a cross-sectional view; and
Fig. 8(b) is a view from above;
Fig. 9 illustrates another application of a vacuum chuck in accordance with an embodiment of the present invention, in the context of an etching process; and
Fig. 10 illustrates a further application of a vacuum chuck in accordance with an embodiment of the present invention, in which wafers are held by their back or reverse surfaces, and an etching process is effected for each wafer in turn.

Throughout the drawings, the same reference numerals designate the same or similar parts.

In the following description of embodiments of the invention reference will be made to the treatment or handling of semiconductor wafers. However, it will be appreciated that embodiments of the invention are not restricted to use for the treatment or handling of such wafers. They can be applied to the treatment or handling of other objects. Moreover, the shape of the object handled is not necessarily that of a wafer. The object need not be flat, it may be cube- or ball-like, for example.

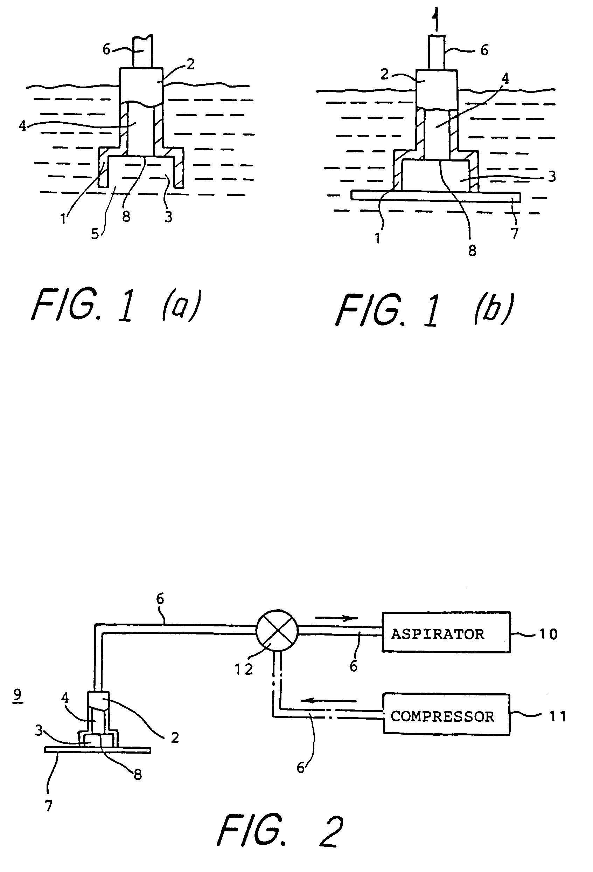

Figs. 1 give schematic partially cut-away views of a vacuum chuck embodying the present invention. The appearance of the chuck is similar to that of an ordinary vacuum chuck. The chuck is basically composed of a head 1 and its holder 2. There is a cavity 3 in the head 1, and there is a manifold 4 in the holder 2. The manifold 4 and the cavity 3 are connected to each other, the bottom (as seen in Fig. 1) of the cavity 3 is opened to form an inlet 5, and the other end of the manifold 4 is connected to a hydraulic hose 6 which is connected to an aspirator (not shown). When the chuck is evacuated by the aspirator, it attracts a wafer 7, and the inlet 5 is closed by the wafer 7.

The vacuum chuck embodying the present invention has a liquid-gas separating membrane 8 attached between the inlet 5 and the manifold 4. In the embodiment of Fig. 1, the liquid-gas separating membrane 8 is spanned over the junction plane of the manifold 4 and the cavity 3. The liquid-gas separating membrane is a hydrophobic membrane having a plurality of tiny holes therein, which pass gas but do not pass liquid. So, as shown in Fig. 1(a), when the vacuum chuck is immersed into a liquid, the liquid is dammed at the liquid-gas separating membrane 8, and does not go further into the manifold 4. When the vacuum chuck is evacuated (the process will be described later), the chuck attracts the wafer 7 as shown in Fig. 1(b). Such operation is similar to that of ordinary vacuum chucks operated in air ambient.

A basic composition of a vacuum chucking system embodying the present invention is illustrated in Fig. 2. It comprises a vacuum chuck 9, an aspirator 10, a compressor 11 and a switching valve 12. The elements (apart from the chuck) may all be conventional. The compressor may be replaced by any suitable compressed gas supplier. Hydraulic hoses 6 connect between the switching valve 12 and the chuck 9, the aspirator 10 and the compressor 11 respectively. When the switching valve 12 is switched to the compressor 11, the compressed air (or gas) expels liquid in the chuck 9, and when the switching valve 12 is switched to the aspirator, the chuck 9 sucks the wafer 7 to the inlet 5 and holds it in a manner similar to that of an ordinary vacuum chuck.

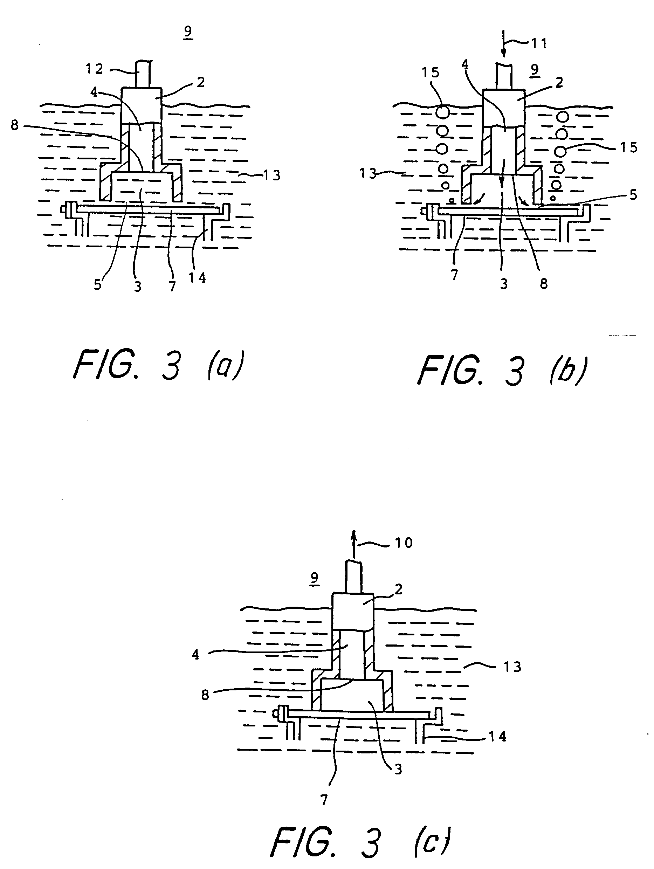

Figs. 3 illustrate a procedure in accordance with which a vacuum chuck embodying the present invention is operated. In this example, a wafer 7 is immersed in a liquid 13, and positioned on a supporter 14. First, the chuck 9 is immersed into the liquid and positioned over the wafer 7 as shown in Fig. 3(a). At this stage, the liquid 13 may intrude into the cavity 3 but it cannot go further into the manifold 4, because the liquid is dammed by the liquid-gas separating membrane 8. Usually, the liquid is stopped before it reaches the liquid-gas separating membrane 8, because there is remaining gas in the cavity 3. So, the surface of the liquid in the cavity 3 is lower than the level of the liquid-gas separating membrane 8. The liquid level in the cavity 3 as shown in Fig. 3(a) is the highest possible liquid level actually.

Next, the switching valve 12 is switched to the compressor, so, as shown in Fig. 3(b), the liquid in the cavity is expelled from the cavity 3, and bubbles 15 come out from the inlet 5 of the head 1. The pressure of the gas (nitrogen for example) compressed by the compressor 11 need not be very high. The ambient pressure plus a hydrostatic pressure at the bottom of the liquid chamber is sufficient. Too high a gas pressure may cause damage to the liquid-gas separating membrane. When the head 1 is brought close to the wafer, keeping the inlet 5 parallel to the surface of the wafer, the liquid over the wafer beneath the head 1 is also purged.

After the gas in the cavity 3 is removed, the switching valve 12 (not shown) is switched to the aspirator to exhaust the gas in the chuck. Then, as shown in Fig. 3(c), the wafer 7 is sucked toward the chuck and the inlet of the head 1 is closed by the wafer 7. In this instance, some of the liquid may intrude into the cavity 3, but actually, the inlet 5 is closed very quickly by the wafer 7, and the amount of intruded liquid is very small compared to the volume of the cavity 3, and the operation of the chuck is not harmed.

It should be noted that if the chuck is held loosely, the chuck is attracted to the wafer as shown in Fig. 3(c), rather than the wafer 7 being lifted up towards the chuck. Such loose or soft holding of the chuck is more desirable than is a firm or stiff holding of the chuck, because if the wafer size is large, the resistance of the liquid to the vertical motion of the wafer, against the broad surface of the wafer, becomes large, so the wafer may be broken if it is lifted up suddenly. After the inlet of the chuck is closed perfectly by the wafer, the chuck may be moved carefully. Even if the wafer were broken accidentally, liquid would not penetrate through the liquid-gas separating membrane 8, and the system would not be harmed.

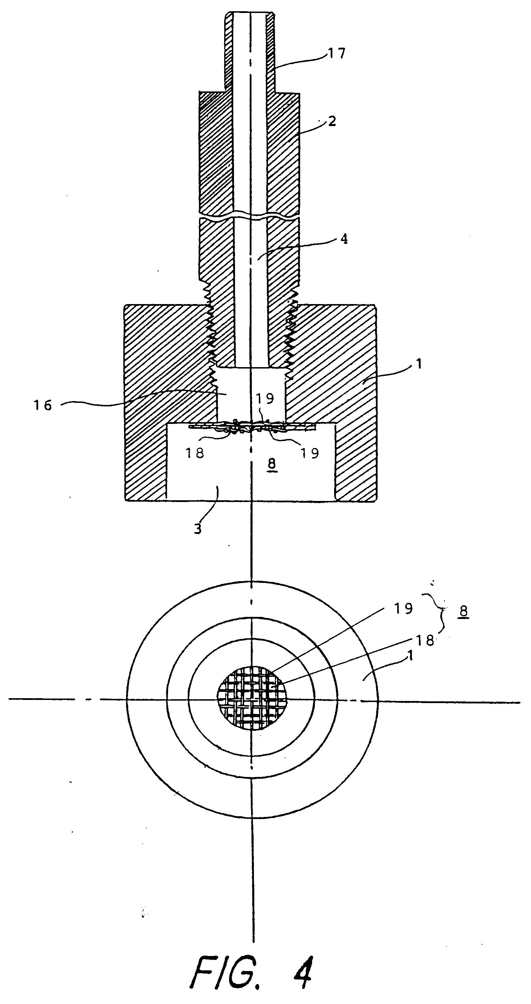

Fig. 4 shows a cross-section (upper part of the Figure) and a bottom end view (lower part of the Figure) of a vacuum chuck in accordance with an exemplary embodiment of the present invention. This type of the chuck is convenient to handling wafers in a horizontal position. The head 1 and holder 2 are made of polytetrafluoroethylene (PTFE) for example. They are screwed to one another in the illustrated example, but they may be fabricated as a one body by molding. The diameter of the head is 30 mm, and its height is 25 mm, for example. The diameter of the cavity 3 is 20 mm, and the height of the cavity is 10 mm, for example. The length of the holder 2 is about 150 mm, and the diameter of the holder is about 15 mm, for example. One end of the holder 2 is shaped to form a nozzle 17 to be fixed to the hydraulic hose 6 (not shown). The inner diameter of the manifold 4 is 4 mm at the holder for example, but as can be seen in the Figure, the diameter of the manifold 4 at the opening to the cavity 3 becomes large (about 8 mm for example) because the holder 2 is screwed into the head 1. This portion forms a second cavity 16. It is desirable to make the opening of the manifold large compared to its remaining part as shown in Fig. 4, because this reduces resistance to gas flow through the liquid-gas separating membrane 8 which is positioned at the opening of the manifold.

The liquid-gas separating membrane 8 is composed of two parts. The first part is a membrane 18 made of PTFE. It is processed to provide a porous membrane of 0.07 mm thickness having a plurality of pores. The pore size is about 0.1 µm. Gas molecules can pass through these tiny pore holes, but liquid cannot. So, gas is separated from the liquid. The membrane 18 is supported at both of its surfaces by the second part 19 of the membrane 8 which are meshes woven of fiber of 0.2 mm in diameter made from tetrafluoroethylene-perfluoroalkylvinylether copolymer (PFA), for example. The liquid-gas separating membrane 8 is welded onto the surface of the cavity 1 covering the opening of the manifold 4. In the embodiment of Fig. 4, the liquid-gas separating membrane 8 is welded around the opening of the second cavity 16. With such a structure, the liquid-gas separating membrane 8 can bear the pressure of liquid even when one side of the membrane is evacuated by the aspirator.

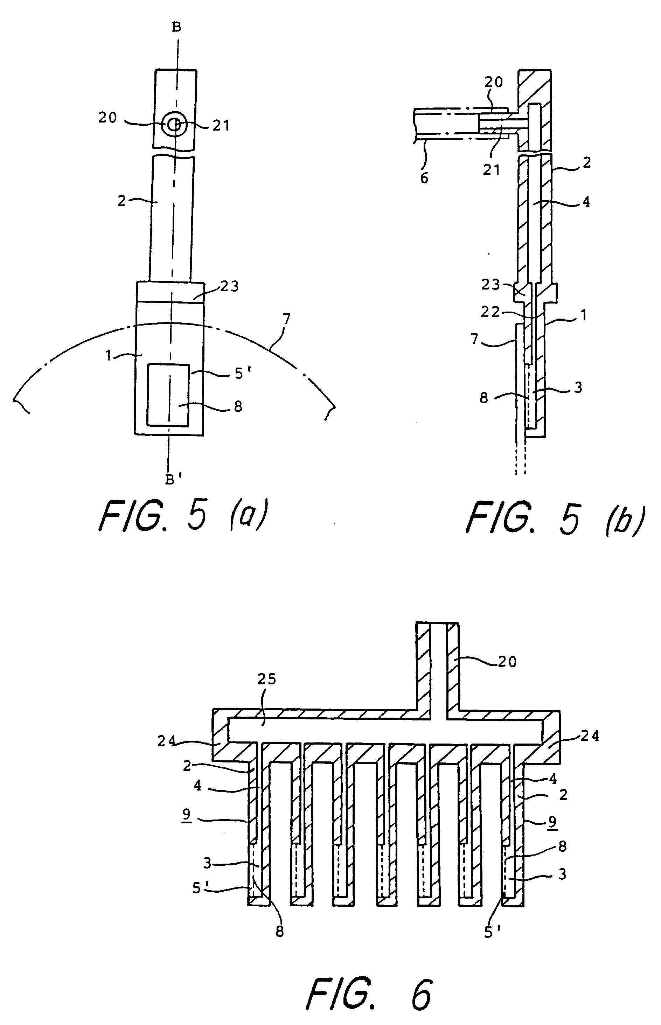

Fig. 5 schematically illustrates the structure of a vacuum chuck in accordance with another exemplary embodiment of the present invention. This embodiment is suitable for holding a wafer 7 vertically. Fig. 5(a) is a front view, and Fig. 5(b) is a cross-sectional view taken along the chain line BB′ in Fig. 5(a). The head 1 is held by a cylindrical holder 2. One end of manifold 4 in the holder 2 is linked to a core hole 21 of a pipe 20, and the latter is connected to the switching valve (not shown) by the hydraulic hose 6. The head 1 is shaped like a flat box having a cavity 3 in it. The cavity 3 is connected to the manifold 4 via a second manifold 22 in the head 1. On one vertical wall of the cavity 3 is formed a rectangular inlet 5′, 1 x 1.5 cm² in extent for example. At the opening of the cavity to the rectangular inlet 5′ a liquid-gas separating membrane 8 is provided. Though further details of the sizes of various parts of the chuck are not given, it will be easy for the man skilled in the art to arrive at suitable sizes, for example by considering the above example of the inlet size. The material of the various elements in the embodiment of Fig. 5 may be the same as those used in the embodiment in Fig. 4.

The operation of the vacuum chuck shown in Fig. 5 is similar to the operation described with reference to Figs. 2 and 3. The head 1 is immersed into the liquid (not shown) and positioned to the upper edge portion of a wafer 7 with the inlet 5′ facing towards the wafer 7. In this case an eaves portion 23 of the head 1 is convenient for determining the position of the head as against the wafer 7. The liquid outside the inlet 5′ is purged by compressed gas. At this stage, the liquid in the inlet 5′ outside the liquid-gas separating membrane 8 is almost (substantially all) purged, even though the membrane is spanned vertically, because the pressure difference of the liquid over the liquid-gas separating membrane 8 is negligible, and the gas comes out over all the area of the liquid-gas separating membrane. Then the switching valve is switched to the aspirator, so the wafer 7 is sucked to the head 1. If some quantity of liquid remains outside the liquid-gas separating membrane 8, it does not harm operations, because it is dammed by the liquid-gas separating membrane.

The holding force of the chuck depends on the size of the inlet and the vacuum in the chuck. An inlet size of 1 x 1.5 cm² and a vacuum of about 100 mm Hg obtained by an ordinary aspirator provides a holding force of about 1.3 kg weight. This is enough for holding the wafer tightly to the chuck and handling it in various ways.

Fig. 6 shows schematically a cross-section of a vacuum chuck in accordance with a further exemplary embodiment of the present invention, which is useful for handling a plurality of wafers at one time. In this embodiment, seven chucks 9 as shown in Fig. 5 are assembled to one common arm 24 by fixing the holders 2 of the chucks to the arm. The manifold 4 of each chuck is linked to a common manifold 25, and the latter is connected to the switching valve (not shown) via a pipe 20 and hydraulic hose (not shown). Materials and sizes of the chucks 9 may be the same or similar to those of Fig. 5. The common arm 24 may also be made of PTFE.

The operation of the embodiment of Fig. 6 is similar to that of the embodiment of Fig. 5. With the embodiment of Fig. 6, seven wafers can be handled at a time. It should be noted that even if the number of wafers is less than the number of the chucks, the system can be operated similarly, because the liquid-gas separating membrane of an unused chuck stops the flow of liquid into the cavity of its head. Further, even if one of the wafers is broken or dropped off from the chuck accidentally, that does not harm the operation of other chucks. This is because the volume of the inlet 5′ outside of the liquid-gas separating membrane 8 is small compared to the total volume of the cavities 3, the manifolds 4 and the common manifold 25. So, a pressure increase caused by the breaking or dropping of a wafer is negligible in the remaining cavities which are holding wafers. Further, the aspirator is evacuating the common manifold 25 all the time, so the effect is further reduced. It will be clear that the shape of the head or the inlet may be varied in a variety of ways according to the application for which the chuck or chucks are intended. The number of the chucks also may be varied.

Next, some exemplary applications of vacuum chucking systems employing embodiments of the present invention will be described.

First, the washing or cleaning of a chuck will be described. It is important to wash or rinse the chuck to keep it clean. It is easy to wash or rinse the chuck in detergent or water. The chuck is immersed in the detergent or water as shown in Figs. 3(a) or 3(b), in this case the wafer 7 and its supporter 14 are removed. The switching valve is switched to compressor or aspirator repeatedly. At each switching, detergent or water is filled or purged into/from the cavity 3, so the chuck is easily cleaned.

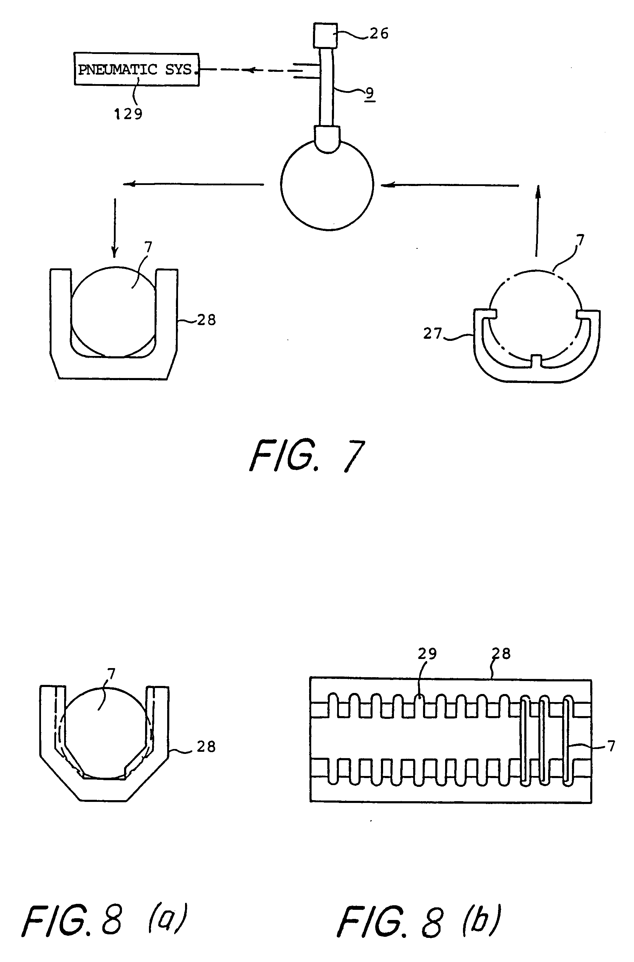

Fig. 7 illustrates the use of a chuck in accordance with the embodiment of Fig. 5 for reloading wafers from one wafer holder to another. Consider a case in which wafers 7 mounted on a wafer holder 27 which is made from silicon (suitable for etching processes) are to be reloaded into a carrier holder 28 which is made from plastic for example, or vice versa. A vacuum chuck 9 as in Fig. 5 is used. The chuck is fixed to an arm 26 which is movable to left and right, and up and down. The chuck is connected to a pneumatic system 129, which comprises a switching valve, an aspirator and a compressor as shown in Fig. 2. The operation is similar to that included when an ordinary vacuum chuck is used in air. Wafers 7 are taken out from the wafer holder 27 by the chuck 9 and inserted into the carrier holder 28 one-by-one. However, using the vacuum chuck embodying the present invention, it is possible to effect such wafer handling both in air and in liquid ambient. Further, if a vacuum chuck as in the embodiment of Fig. 6 is used, a plurality of wafers can be handled at one time.

Figs. 8 illustrate an exemplary type of wafer holder, used in various processes. Fig. 8(a) is a side view, and Fig. 8(b) is a plan view of the holder. Wafers 7 are placed in grooves 29 in the holder. If a wet process is carried out using such a wafer holder, it leaves drops of liquid at the contact portions of the wafers to the holder, and sometimes leaves stains on the wafer. Using a vacuum chuck embodying the present invention, it is easy to prevent such defects. The method will be described with respect to an etching process as an example.

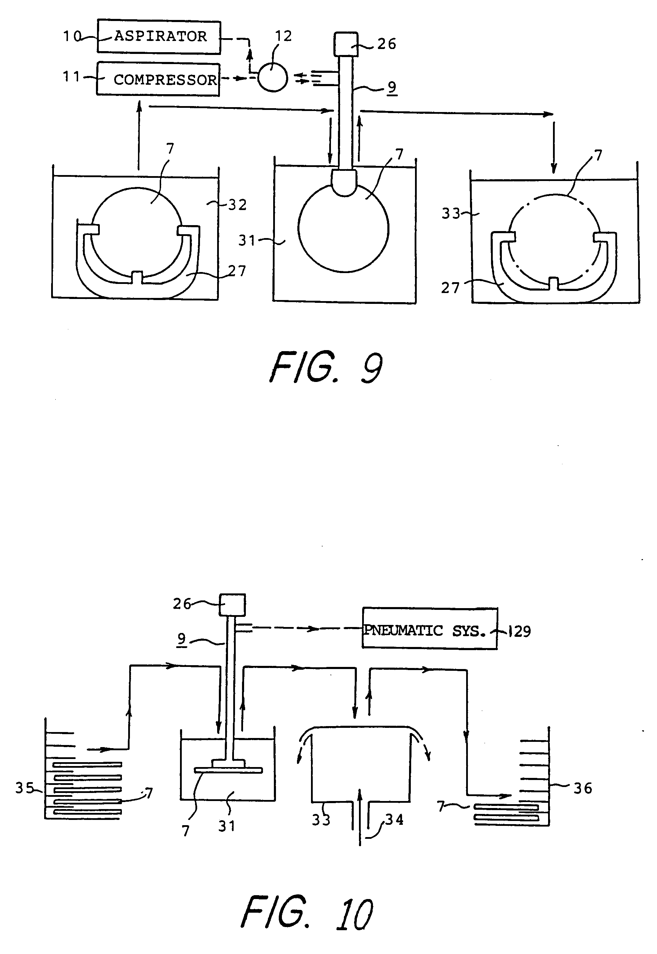

Fig. 9 illustrates a system for carrying out a wet process, an etching process for example. An etching tab (a bath or tub) 31 contains an etchant, a front tab 32 contains wafers 7 to be etched, and a rinsing tab 33 contains rinsing liquid which is usually water. The front tab may contain other processing liquid or it may be a simple air container. The wafers 7 are placed on a wafer holder 27. A vacuum chuck 9 of the Fig. 5 type which is fixed to an arm 26 is used. The arm 26 is movable to left and right, and up and down, keeping the chuck 9 vertical. Hold and release of the vacuum chuck 9 is controlled by an aspirator 10, a compressor 11 and a switching valve 12, in a manner as described before.

The wafers 7 are taken out one-by-one by the vacuum chuck 9 from the front tab 32. Each wafer 7 is chucked from its back side. So, the front side which requires most uniform etching is not contacted by anything. The chuck 9 is moved along a path indicated by arrows, and dips the wafer 7 into the etching tab 31 holding the wafer from its back side. When the etching is finished, the chuck 9 brings the wafer into the rinsing tub 33, and releases the wafer into the holder 27, where the etchant is quenched and the wafer is rinsed. In such manner, the wafer is held from its reverse side, the front side is free from irregular etching or stains caused by contact with the holder.

Fig. 10 illustrates another application of a chuck holder embodying the present invention, in this case of the Fig. 3 type. Description will be given in relation to an etching process for example but any other kind of wet processing might be involved. The vacuum chuck 9 is a type as described with reference to Fig. 3. The chuck is held by an arm 26 and controlled by a pneumatic system 129. The arm and the pneumatic system are similar to those of Figs. 7 or 9. A loading wafer holder 35, and unloading wafer holder 36 hold wafers 7 horizontally. Each of the wafers is placed on a wafer holder with its front surface, which is the surface to be etched, downward. The chuck 9 takes out the wafers one-by-one holding them from the back or reverse side, and moves along a path as shown by arrows, immersing a wafer into the etching tab (bath or tub) 31. After the etching is finished, the wafer is taken out from the etching tab 31 and immersed into rinsing tab 33. In the rinsing tab 33 rinsing water 34 is fed from the bottom of the tab, and overflows the tab. The wafer is held in the water keeping the front side downward, so the front side always meets fresh rinsing water. This is effective to rinse the front side quickly and provide a uniform etching over the entire front surface. When the rinse is finished, the wafer is released into receiving wafer holder 36. It will be apparent that in this system etchant staining resulting from contact with the holder is eliminated.

In the above-described applications of vacuum chucks in accordance with embodiments of the present invention to various wet processes, the chuck may be moved by hand or moved automatically using a robot or an automatic mechanism. Equipment such as aspirators, compressors, wafer holders, etching tabs (tubs or baths) and so on may all be conventional ones, so further description is omitted.

Structures, operations and some fundamental applications of vacuum chucking systems in accordance with embodiments of the present invention have been described above. It will be apparent however that many modifications are possible; for example, materials may be varied from the ones described, the shapes of chuck and inlet holes may be varied. The object handled by the vacuum chuck is not limited to a semiconductor wafer; the chuck may be applied to handle a cube or ball-like object. Those modifications are all within the scope of the present invention.

Embodiments of the present invention provide vacuum chucks which can be operated both in gas and in liquid. The vacuum chuck is provided with a liquid-gas separating membrane having a plurality of tiny holes which allow passage of gas molecules but do not pass liquid. The liquid-gas separating membrane is spanned between an inlet hole of the chuck and a manifold which, in operation of the chuck, is connected to a pneumatic system. The pneumatic system comprises an aspirator, a compressor and a switching valve. The vacuum chuck is immersed into a liquid, compressed gas purges the liquid in the inlet hole, then the switching valve is switched to the aspirator. So, an object such as a semiconductor wafer is sucked quickly to the chuck, and the inlet hole is closed by the object. If a small quantity of liquid intrudes into the chuck, it cannot pass through the liquid-gas separating membrane, and operation of the chuck is not harmed.

## Claims

1. A vacuum chucking tool operable in a liquid and comprising a vacuum chuck (9) capable of being evacuated or pressurized when connected to a pneumatic system (129), for clamping or releasing an object (7) to or from the vacuum chuck, the vacuum chuck having:-
a head (1) for holding the object;
a cavity (3) formed in the head (1);
an inlet (5) formed in the head (1) for sucking the object towards the head (1), the inlet (5) being connected to the cavity (3);
a holder (2) for supporting the head (1);
a connection means (6) provided on the holder (2) for connecting the chuck to the pneumatic system (129);
a manifold (4) formed in the holder (2), for connecting the cavity (3) to the connection means (6);
and
a liquid-gas separating membrane (8) for separating gas from liquid in a mixture of liquid and gas, the liquid-gas separating membrane (8) being spanned between the cavity (3) and the manifold (4), or between the cavity (3) and the inlet (5).

2. A vacuum chucking tool as claimed in claim 1, the vacuum chucking tool comprising a plurality of vacuum chucks as set forth in claim 1, the chucks being arranged in parallel to each other.

3. A vacuum chucking tool as claimed in claim 1 or 2, wherein the liquid-gas separating membrane (8) in the or each vacuum chuck comprises a membrane having a plurality of tiny holes through which gas molecules may pass but not liquid.

4. A vacuum chucking tool as claimed in claim 1, 2 or 3, wherein the inlet (5) of the or each vacuum chuck is formed in a bottom surface of the head (1) of the chuck.

5. A vacuum chucking tool as claimed in claim 1, 2 or 3, wherein the inlet (5) of the or each vacuum chuck is formed in a side wall of the head (1) of the chuck.

6. A vacuum chucking system, comprising a vacuum chucking tool as claimed in any preceding claim and a pneumatic system (129) operable to evacuate or pressurize the or each vacuum chuck, for clamping or releasing an object to or from the vacuum chuck.

7. A vacuum chucking system as claimed in claim 6, wherein the pneumatic system comprises:-
an aspirator (10) for evacuating the or each vacuum chuck;
a compressed gas means (11) for sending compressed gas to the or each vacuum chuck; and
a switching valve (12) connected between the vacuum chucking tool and the aspirator (10) and the compressed gas means (11), for switching connection of the vacuum chucking tool to the aspirator (10) or to the compressed gas means (11).

## Patentansprüche

1. Ein Vakuumspannwerkzeug, das in einer Flüssigkeit betriebsfähig ist und eine Vakuumspannvorrichtung (9) umfaßt, die evakuiert oder unter Druck gesetzt werden kann, wenn sie mit einem pneumatischen System (129) verbunden ist, zum Festspannen oder Freigeben eines Objektes (7) an die oder von der Vakuumspannvorrichtung, die umfaßt:-
einen Kopf (1) zum Halten des Objektes;
einen Hohlraum (3), der in dem Kopf (1) gebildet ist;
einen Einlaß (5), der in dem Kopf (1) gebildet ist, zum Ansaugen des Objektes zum Kopf (1), welcher Einlaß (5) mit dem Hohlraum (3) verbunden ist;
einen Halter (2) zum Stützen des Kopfes (1);
ein Verbindungsmittel (6), das am Halter (2) vorgesehen ist, zum Verbinden der Spannvorrichtung mit dem pneumatischen System (129);
ein Verteilerstück (4), das in dem Halter (2) gebildet ist, zum Verbinden des Hohlraumes (3) mit dem Verbindungsmittel (6); und
eine Flüssigkeits-Gas-Trennmembrane (8) zum Trennen von Gas von einer Flüssigkeit in einer Mischung von Flüssigkeit und Gas, welche Flüssigkeits-Gas-Trennmembrane (8) zwischen den Hohlraum (3) und das Verteilerstück (4) oder zwischen den Hohlraum (3) und den Einlaß (5) gespannt ist.

2. Ein Vakuumspannwerkzeug nach Anspruch 1, welches Vakuumspannwerkzeug eine Vielzahl von Vakuumspannvorrichtungen nach Anspruch 1 umfaßt, welche Spannvorrichtungen parallel zueinander angeordnet sind.

3. Ein Vakuumspannwerkzeug nach Anspruch 1 oder 2, bei dem die Flüssigkeits-Gas-Trennmembrane (8) in der oder jeder Vakuumspannvorrichtung eine Membrane umfaßt, die eine Vielzahl von winzigen Löchern hat, durch die Gasmoleküle hindurchgelangen können, aber Flüssigkeit nicht.

4. Ein Vakuumspannwerkzeug nach Anspruch 1, 2 oder 3, bei dem der Einlaß (5) der oder jeder Vakuumspannvorrichtung in einer Bodenoberfläche des Kopfes (1) der Spannvorrichtung gebildet ist.

5. Ein Vakuumspannwerkzeug nach Anspruch 1, 2 oder 3, bei dem der Einlaß (5) der oder jeder Vakuumspannvorrichtung in einer Seitenwand des Kopfes (1) der Spannvorrichtung gebildet ist.

6. Ein Vakuumspannsystem, das ein Vakuumspannwerkzeug nach irgendeinem vorhergehenden Anspruch und ein pneumatisches System (129) umfaßt, das betriebsfähig ist, um die oder jede Vakuumspannvorrichtung zu evakuieren oder unter Druck zu setzen, zum Festspannen oder Freigeben eines Objektes an die oder von der Vakuumspannvorrichtung.

7. Ein Vakuumspannsystem nach Anspruch 6, bei dem das pneumatische System umfaßt:-
eine Saugpumpe (10) zum Evakuieren der oder jeder Vakuumspannvorrichtung;
ein Druckgasmittel (11) zum Leiten von Druckgas zu der oder jeder Vakuumspannvorrichtung; und
ein Schaltventil (12), das zwischen dem Vakuumspannwerkzeug und der Saugpumpe (10) und dem Druckgasmittel (11) verbunden ist, zum Schalten der Verbindung des Vakuumspannwerkzeuges zu der Saugpumpe (10) oder zu dem Druckgasmittel (11).

## Revendications

1. Outil de serrage sous vide destiné à fonctionner dans un liquide et comprenant un mandrin aspirant (9) qui peut être mis sous vide ou sous pression lorsqu'il est relié à un ensemble pneumatique (129) de manière qu'un objet (7) soit serré sur le mandrin aspirant ou libéré par celui-ci, le mandrin aspirant comprenant
une tête (1) de support de l'objet,
une cavité (3) formée dans la tête (1),
une entrée (5) formée dans la tête (1) et destinée à aspirer l'objet vers la tête (1), l'entrée (5) étant reliée à la cavité (3),
un support (2) destiné à supporter la tête (1),
un dispositif (6) de raccordement placé sur le support (2) et destiné à raccorder le mandrin à un ensemble pneumatique (129),
un collecteur (4) formé dans le support (2) et destiné à raccorder la cavité (3) au dispositif de raccordement (6), et
une membrane (8) de séparation liquide-gaz destinée à séparer le gaz du liquide dans un mélange de liquide et de gaz, la membrane (8) de séparation liquide-gaz s'étendant entre la cavité (3) et le collecteur (4) ou entre la cavité (3) et l'entrée (5).

2. Outil de serrage par aspiration selon la revendication 1, l'outil comprenant plusieurs mandrins aspirants selon la revendication 1, les mandrins étant placés parallèlement les uns aux autres.

3. Outil de serrage par aspiration selon la revendication 1 ou 2, dans lequel la membrane (8) de séparation liquide-gaz du mandrin aspirant ou de chaque mandrin aspirant est une membrane ayant plusieurs trous minuscules par lesquels peuvent passer des molécules de gaz mais pas un liquide.

4. Outil de serrage par aspiration selon la revendication 1, 2 ou 3, dans lequel l'entrée (5) du mandrin aspirant ou de chaque mandrin aspirant est formée à la face inférieure de la tête (1) du mandrin.

5. Outil de serrage par aspiration selon la revendication 1, 2 ou 3, dans lequel l'entrée (5) du mandrin aspirant ou de chaque mandrin aspirant est formée dans une paroi latérale de la tête (1) du mandrin.

6. Ensemble de serrage par aspiration, comprenant un outil de serrage par aspiration selon l'une des revendications précédentes et un ensemble pneumatique (129) destiné à évacuer le mandrin ou chaque mandrin aspirant ou à le mettre sous pression, afin qu'un objet soit serré sur le mandrin aspirant ou libéré de celui-ci.

7. Ensemble de serrage selon la revendication 6, dans lequel l'ensemble pneumatique comporte
un aspirateur (10) destiné à évacuer le mandrin aspirant ou chaque mandrin aspirant,
un dispositif (11) à gaz comprimé destiné à transmettre un gaz comprimé au mandrin ou à chaque mandrin aspirant, et
une soupape (12) de commutation, raccordée entre l'outil de serrage et l'aspirateur (10), et le dispositif (11) à gaz comprimé afin qu'elle commute le raccordement de l'outil de serrage par aspiration vers l'aspirateur (10) ou le dispositif (11) à gaz comprimé.
